# EUROPEAN PATENT APPLICATION

(11) **EP 3 760 470 A1**
(43) Date of publication of application: **06.01.2021**
(21) Application number: 18907753.0
(22) Date of filing: 27.04.2018
(51) Int. Cl.: B60L 50/50, G01R 31/08

(54) **METHOD AND APPARATUS FOR DETECTING CONNECTION STATE BETWEEN BATTERY AND VEHICLE BODY, AND CONTROLLER AND MEDIUM**

(30) Priority: 02.03.2018 CN 201810175306
(71) Applicant: NIO (ANHUI) HOLDING CO., LTD, Economic and Technological Development Zone Hefei Anhui 230601 (CN)
(72) Inventor: HAO, Zhanduo, Shanghai 201804 (CN); CHEN, Jiong, Shanghai 201804 (CN); MA, Jun, Shanghai 201804 (CN)
(74) Representative: Bjerkéns Patentbyrå KB (Gävle)
(86) International application number: PCT/CN2018/084891
(87) International publication number: WO 2019/165700

(57) **Abstract**

Provided are a method and apparatus for detecting a connection state between a battery and a vehicle body, a controller and a medium. The method comprises: detecting a contact resistance between one or more vehicle body fasteners and the battery to obtain a detected value of the contact resistance; and determining the connection state between the battery and the vehicle body according to the detected value of the contact resistance and a preset contact resistance threshold. Whether the fastener is tightened in place is determined by detecting the contact resistance between the battery and the vehicle body fastener, so as to determine whether the battery is firmly installed. The detection process is simple, and detection results are reliable, thereby ensuring the reliability and safety of battery swapping and the safe driving of a vehicle after battery swapping.

## Description

### Technical Field

The invention relates to the technical field of electric vehicles, and in particular, to a method and apparatus for detecting a connection state between a battery and a vehicle body, a controller and a medium.

### Background Art

The long charging time and inconvenience in use of electric vehicles are main factors that affect the large-scale development of electric vehicles. Therefore, a technology of battery swapping for electric vehicles has emerged. Battery swapping is a rapid energy supplement method for electric vehicles, and specifically refers to an energy supplement method in which traction batteries of an electric vehicle are removed through a battery swap device and immediately replaced by another group of traction batteries. A battery swap station is a place for implementing swapping of traction batteries of electric vehicles.

The safety and reliability of the vehicle after battery swapping are the basic requirements for battery swapping. The battery is usually fixed to a vehicle body via fasteners. With respect to a chassis battery swapping way, installing and fixing the battery firmly on a vehicle chassis is the premise of safe and reliable driving of the vehicle, and also the basis of successful battery swapping. Therefore, how to accurately determine whether the battery is installed in place after battery swapping and whether there is a potential safety hazard of the battery falling during driving have become urgent technical problems to be solved.

### Summary of the Invention

The technical problems to be solved by the invention are to provide a method and apparatus for detecting a connection state between a battery and a vehicle body, a controller and a medium. Whether the fastener is tightened in place is determined by detecting the contact resistance between the battery and the vehicle body fastener, so as to determine whether the battery is firmly installed. The detection process is simple, and detection results are reliable, thereby ensuring the reliability and safety of battery swapping and the safe driving of a vehicle after battery swapping.

In order to solve the above technical problems, in one aspect of the invention, a method for detecting a connection state between a battery and a vehicle body is provided, the method comprising:
detecting a contact resistance between one or more vehicle body fasteners and the battery to obtain a detected value of the contact resistance; and
determining the connection state between the battery and the vehicle body according to the detected value of the contact resistance and a preset contact resistance threshold.

Further, the step of detecting a contact resistance between one or more vehicle body fasteners and the battery to obtain a detected value of the contact resistance comprises:
detecting a contact resistance between each of the vehicle body fasteners and the battery one by one to obtain a detected value of the contact resistance between each of the vehicle body fasteners and the battery.

Further, the step of detecting a contact resistance between each of the vehicle body fasteners and the battery one by one to obtain a detected value of the contact resistance between each of the vehicle body fasteners and the battery comprises:
connecting a detection circuit between each of vehicle body detection points and a corresponding battery detection point; and
acquiring a contact resistance value between each of the vehicle body detection points and the corresponding battery detection point by the detection circuit,
wherein each of the vehicle body fasteners is provided with one of the vehicle body detection points, the battery detection points are all located on the battery side, and each of the vehicle body detection points corresponds to one battery detection point.

Further, the step of determining the connection state between the battery and the vehicle body according to the detected value of the contact resistance and a preset contact resistance threshold comprises the following steps of:
comparing the detected value of the contact resistance between each of the vehicle body fasteners and the battery with a contact resistance threshold between the corresponding vehicle body fastener and the battery; and
determining that the battery is firmly connected to the vehicle body if the detected value of the contact resistance between each of the vehicle body fasteners and the battery is less than the contact resistance threshold between the corresponding vehicle body fastener and the battery, otherwise determining that the battery is loosely connected to the vehicle body.

Further, the step of detecting a contact resistance between one or more vehicle body fasteners and the battery to obtain a detected value of the contact resistance comprises:
assuming that there are **M** vehicle body fasteners on an electric vehicle, where **M** is an integer greater than or equal to 2,
dividing the **M** vehicle body fasteners into **N** groups, where **N** is an integer greater than or equal to 1, each group comprising **P** vehicle body fasteners, where **2** ≤ **P** ≤ **M**, and the **N** groups of fasteners comprising every vehicle body fastener on the vehicle; and
detecting a contact resistance between each group of vehicle body fasteners and the battery to obtain a detected value of the contact resistance between each group of vehicle body fasteners and the battery,
wherein each of the vehicle body fasteners is provided with one vehicle body detection point, the battery detection points are all located on the battery side, and each of the vehicle body detection points corresponds to one battery detection point.

Further, the step of detecting a contact resistance between each group of vehicle body fasteners and the battery to obtain a detected value of the contact resistance between each group of vehicle body fasteners and the battery comprises:
on the vehicle body side, connecting in series vehicle body detection points corresponding to all the vehicle body fasteners in each group, and reserving the vehicle body detection points at two ends;
on the battery side, connecting a detection circuit between battery detection points corresponding to the vehicle body detection points at the two ends; and
acquiring a detected value of the contact resistance between each group of vehicle body fasteners and the battery by the detection circuit, wherein the detected value of the contact resistance between each group of vehicle body fasteners and the battery is the sum of the detected values of the contact resistances between the respective vehicle body fasteners in this group and the battery.

Further, the step of detecting a contact resistance between each group of vehicle body fasteners and the battery to obtain a detected value of the contact resistance between each group of vehicle body fasteners and the battery comprises:
on the battery side, connecting in series battery detection points corresponding to all the vehicle body fasteners in each group, and reserving the battery detection points at two ends;
on the vehicle body side, connecting a detection circuit between battery detection points corresponding to the battery detection points at the two ends; and
acquiring a detected value of the contact resistance between each group of vehicle body fasteners and the battery by the detection circuit, wherein the detected value of the contact resistance between each group of vehicle body fasteners and the battery is the sum of the detected values of the contact resistances between the respective vehicle body fasteners in this group and the battery.

Further, the step of determining the connection state between the battery and the vehicle body according to the detected value of the contact resistance and a preset contact resistance threshold comprises:
comparing the detected value of the contact resistance between each group of vehicle body fasteners and the battery with a contact resistance threshold between each group of corresponding vehicle body fasteners and the battery;
wherein the contact resistance threshold between each group of vehicle body fasteners and the battery is the sum of contact resistance thresholds between the respective vehicle body fasteners in this group and the battery; and
determining that the battery is firmly connected to the vehicle body if the detected value of the contact resistance between each group of vehicle body fasteners and the battery is less than the contact resistance threshold between each group of corresponding vehicle body fasteners and the battery, otherwise determining that the battery is loosely connected to the vehicle body.

Further, the contact resistance threshold between each of the vehicle body fasteners and the battery is set according to material parameters corresponding to the positions where each of the vehicle body fasteners and the battery are located, and the material parameters comprise one or more of the following: thickness, density, electrical conductivity, and a resistance value measured when the vehicle body fastener is connected and fastened to the battery.

Further, the method further comprises, if a detected value of the contact resistance between one group of vehicle body fasteners and the battery is greater than or equal to a contact resistance threshold between this group of corresponding vehicle body fasteners and the battery, re-grouping the vehicle body fasteners in this group for contact resistance detection, so as to determine all loose vehicle body fasteners.

Further, the method further comprises giving an alarm if it is determined that the battery is in loose connection with the vehicle body.

In another aspect of the invention, an apparatus for detecting a connection state between a battery and a vehicle body is provided, the battery being connected to the vehicle body via a vehicle body fastener, wherein
the apparatus comprises a detection circuit and a determination module, and the detection circuit is connected to the determination module;
the detection circuit connects vehicle body detection points or battery detection points and is configured for detecting a contact resistance between one or more vehicle body fasteners and the battery to obtain a detected value of the contact resistance; and
the determination module is configured for determining the connection state between the battery and the vehicle body according to the detected value of the contact resistance and a preset contact resistance threshold.

Further, the detection circuit is further configured for connecting each vehicle body detection point to a corresponding battery detection point, and detecting a contact resistance between each of the vehicle body fasteners and the battery one by one to obtain a detected value of the contact resistance between each of the vehicle body fasteners and the battery.

Each of the vehicle body fasteners is provided with one of the vehicle body detection points, the battery detection points are all located on the battery side, and each of the vehicle body detection points corresponds to one battery detection point.

Further, the determination module is further configured for:
comparing the detected value of the contact resistance between each of the vehicle body fasteners and the battery with a contact resistance threshold between the corresponding vehicle body fastener and the battery; and
determining that the battery is firmly connected to the vehicle body if the detected value of the contact resistance between each of the vehicle body fasteners and the battery is less than the contact resistance threshold between the corresponding vehicle body fastener and the battery, otherwise determining that the battery is loosely connected to the vehicle body.

Further, the apparatus further comprises a grouping module:
assuming that there are **M** vehicle body fasteners on an electric vehicle, where **M** is an integer greater than or equal to 2,
the grouping module is configured for dividing the **M** vehicle body fasteners into **N** groups, where **N** is an integer greater than or equal to 1, each group comprising **P** vehicle body fasteners, where **2** ≤ **P** ≤ **M,** and the **N** groups of fasteners comprising every vehicle body fastener on the vehicle, wherein each of the vehicle body fasteners is provided with one of the vehicle body detection points, the battery detection points are all located on the battery side, and each of the vehicle body detection points corresponds to one battery detection point.

Further, the apparatus further comprises a series connection unit configured for connecting in series vehicle body detection points on the vehicle body side that correspond to all the vehicle body fasteners in each group, and reserving the vehicle body detection points at two ends; or
for connecting in series battery detection points on the battery side that correspond to all the vehicle body fasteners in each group, and reserving the battery detection points at two ends.

Further, the detection circuit is further configured for: connecting the reserved vehicle body detection points at the two ends on the vehicle body side, or connecting the reserved battery detection points at the two ends on the battery side, and detecting a contact resistance between each group of vehicle body fasteners and the battery to obtain a detected value of the contact resistance between each group of vehicle body fasteners and the battery, wherein the detected value of the contact resistance between each group of vehicle body fasteners and the battery is the sum of the detected values of the contact resistances between the respective vehicle body fasteners in this group and the battery.

Further, the determination module is further configured for: comparing the detected value of the contact resistance between each group of vehicle body fasteners and the battery with a contact resistance threshold between each group of corresponding vehicle body fasteners and the battery;
wherein the contact resistance threshold between each group of vehicle body fasteners and the battery is the sum of contact resistance thresholds between the respective vehicle body fasteners in this group and the battery; and
determining that the battery is firmly connected to the vehicle body if the detected value of the contact resistance between each group of vehicle body fasteners and the battery is less than the contact resistance threshold between each group of corresponding vehicle body fasteners and the battery, otherwise determining that the battery is loosely connected to the vehicle body.

Further, the contact resistance threshold between each of the vehicle body fasteners and the battery is set according to material parameters corresponding to the positions where each of the vehicle body fasteners and the battery are located, and the material parameters comprise one or more of the following: thickness, density and electrical conductivity.

Further, the apparatus further comprises an alarm module connected to the determination module and configured for giving an alarm when it is determined that the battery is in loose connection with the vehicle body.

According to a still another aspect of the invention, a controller is provided, which comprises a memory and a processor, wherein the memory stores a computer program that, when executed by the processor, is capable of implementing the steps of the method.

According to a yet another aspect of the invention, a computer readable storage medium for storing a computer program is provided, wherein the program, when executed by a computer or a processor, implements the steps of the method.

The invention has obvious advantages and beneficial effects as compared with the prior art. By means of the foregoing technical solutions, the method and apparatus for detecting a connection state between a battery and a vehicle body, the controller and the medium according to the invention can achieve considerable technical progress and practicability, have wide industrial utilization value, and have at least the following advantages.

According to the invention, whether a battery and a vehicle body of a vehicle after battery swapping are firmly connected can be quantitatively detected through a contact resistance. Detection can be performed after the battery swapping is completed to ensure the battery is firmly installed; moreover, real-time detection can also be performed to ensure the battery is firmly connected, and alarm information can be sent when the battery is not firmly connected. In the invention, the detection process is simple, and detection results are reliable, thereby ensuring the reliability and safety of battery swapping and the safe driving of the vehicle after battery swapping, and preventing the battery from falling.

The description above is only summary of the technical solutions of the invention. In order to understand the technical means of the invention more clearly for implementation according to the contents of the specification, and in order to make the above and other objectives, features and advantages of the invention more apparent and easy to be understood, preferred embodiments are especially taken as examples in conjunction with the accompanying drawings, and the detailed description is as follows.

### Brief Description of the Drawings

Fig. 1 is a schematic diagram of the connection between a battery to a vehicle body of an electric vehicle according to an embodiment of the invention;
Fig. 2 is a flowchart of a method for detecting a connection state between a battery and a vehicle body according to an embodiment of the invention;
Fig. 3(a) is a schematic diagram of a firm connection state between a battery of an electric vehicle and a vehicle body and detection points according to an embodiment of the invention;
Fig. 3(b) is a schematic diagram of a loose connection state between a battery of an electric vehicle and a vehicle body and detection points according to an embodiment of the invention;
Fig. 4 is a schematic diagram of a detection circuit according to an embodiment of the invention;
Fig. 5 is a schematic diagram of a vehicle chassis and an installation position of a battery on the vehicle chassis according to an embodiment of the invention;
Fig. 6 is a schematic diagram of a principle of detecting a connection state between a battery and a vehicle body according to an embodiment of the invention; and
Fig. 7 is a schematic diagram of an apparatus for detecting a connection state between a battery and a vehicle body according to an embodiment of the invention.

**Description of reference numerals:**

| | |
|---|---|
| 1: detection circuit | 2: determination module |

### Detailed Description of Embodiments

In order to further illustrate the technical means and effects adopted by the invention to achieve the intended objectives of the invention, specific implementations and effects of a method and apparatus for detecting a connection state between a battery and a vehicle body, a controller and a medium according to the invention are described in detail as follows with reference to the accompanying drawings and preferred embodiments.

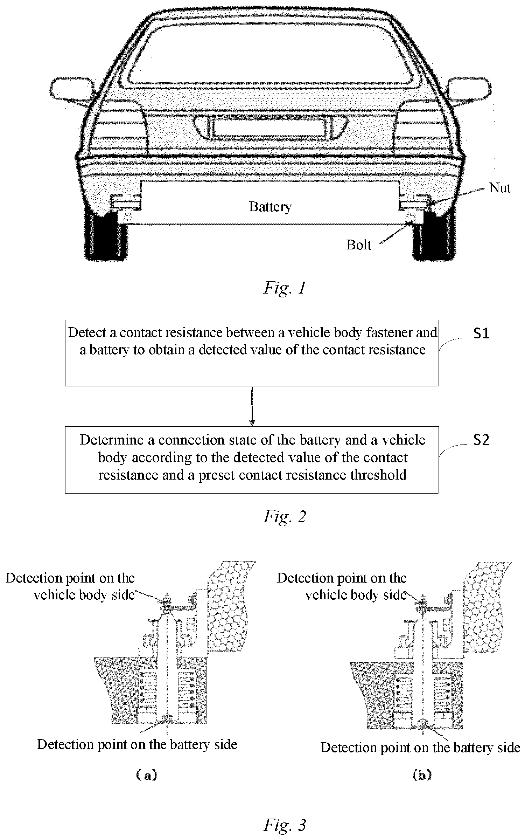

A battery of an electric vehicle is fixed and connected to a vehicle body via a vehicle body fastener. The fastener may be a bolt, etc., as shown in Fig. 1. When the battery is firmly connected to the vehicle body, a contact resistance between a vehicle body nut and a battery bolt should be very small. Once the battery is loosely connected to the vehicle body, the contact resistance will increase. Therefore, in the invention, the connection state between the battery and the vehicle body is detected by detecting the contact resistance.

It should be noted that the electric vehicle generally refers to a vehicle with a swappable battery pack, is not merely limited to a battery electric vehicle, and may be a hybrid vehicle.

The specific detection process is as follows:
as shown in Fig. 2, an embodiment of the invention provides a method for detecting a connection state between a battery and a vehicle body, comprising:
Step S1: detecting a contact resistance between one or more vehicle body fasteners and the battery to obtain a detected value of the contact resistance; and
Step S2: determining the connection state between the battery and the vehicle body according to the detected value of the contact resistance and a preset contact resistance threshold.

The method may further comprise a step S3: giving an alarm if it is determined that the battery is in loose connection with the vehicle body, so as to remind a vehicle owner that the battery is loose and to prevent dangerous driving.

Two embodiments are given below for detailed description.

### First embodiment

Step S11: detecting a contact resistance between each of the vehicle body fasteners and the battery one by one to obtain a detected value of the contact resistance between each of the vehicle body fasteners and the battery.

Step S11 comprises:
Step Sill: connecting a detection circuit between each of vehicle body detection points and a corresponding battery detection point to form a detection loop; and
Step S112: acquiring a contact resistance value between each of the vehicle body detection points and the corresponding battery detection point by the detection circuit,
   wherein each of the vehicle body fasteners is provided with one of the vehicle body detection points, the battery detection points are all located on the battery side, and each of the vehicle body detection points corresponds to one battery detection point. As shown in Fig. 3, a firm connection state and a loose connection state, as well as positions of detection points on the vehicle body side and on the battery side are shown respectively.
Step S12: comparing the detected value of the contact resistance between each of the vehicle body fasteners and the battery with a contact resistance threshold between the corresponding vehicle body fastener and the battery; and
   determining that the battery is firmly connected to the vehicle body if the detected value of the contact resistance between each of the vehicle body fasteners and the battery is less than the contact resistance threshold between the corresponding vehicle body fastener and the battery, otherwise determining that the battery is loosely connected to the vehicle body, that is, the vehicle body fastener with the detected value of the contact resistance greater than the contact resistance threshold is a loose vehicle body fastener.

In step S12, the sum of the detected values of the contact resistances between all the vehicle body fasteners and the battery may also be compared with the sum of contact resistance thresholds between all the corresponding vehicle body fasteners and the battery; if the sum of the detected values of the contact resistances between all the vehicle body fasteners and the battery is less than the sum of the contact resistance thresholds between all the corresponding vehicle body fasteners and the battery, it is determined that the battery is firmly connected to the vehicle body, otherwise it is determined that the battery is loosely connected to the vehicle body.

### Second embodiment

In the actual detection process, since the way to detect a single contact resistance described in the first embodiment is directly used, a detection loop needs to be established between the vehicle body and the battery, and the detection process is relatively difficult. Therefore, the following process can be used for detection:
Step S12: assuming that there are **M** vehicle body fasteners on an electric vehicle, where **M** is an integer greater than or equal to 2,
dividing the **M** vehicle body fasteners into **N** groups, where **N** is an integer greater than or equal to 1, each group comprising **P** vehicle body fasteners, where **2** ≤ **P** ≤ **M,** and the **N** groups of fasteners comprising every vehicle body fastener on the vehicle.

It should be noted that there are multiple grouping methods, which can be set according to specific detection requirements. For example, they can be detected in pairs, that is, two-by-two detection, or three, four, etc. fasteners per group may be detected. The number of vehicle body fasteners contained in each group may be the same or different, and the same vehicle body fastener may be assigned to multiple groups, as long as all the vehicle body fasteners are grouped.

Step S13: detecting a contact resistance between each group of vehicle body fasteners and the battery to obtain a detected value of the contact resistance between each group of vehicle body fasteners and the battery.

The contact resistance between each group of vehicle body fasteners and the battery can be detected by using the following two ways.

### First way

On the vehicle body side, vehicle body detection points corresponding to all the vehicle body fasteners in each group are connected in series, and the vehicle body detection points at two ends are reserved;
on the battery side, a detection circuit is connected between battery detection points corresponding to the vehicle body detection points at the two ends; and
a detected value of the contact resistance between each group of vehicle body fasteners and the battery is acquired by the detection circuit, wherein the detected value of the contact resistance between each group of vehicle body fasteners and the battery is the sum of the detected values of the contact resistances between the respective vehicle body fasteners in this group and the battery.

### Second way

On the battery side, battery detection points corresponding to all the vehicle body fasteners in each group are connected in series, and the battery detection points at two ends are reserved;
on the vehicle body side, a detection circuit is connected between battery detection points corresponding to the battery detection points at the two ends; and
a detected value of the contact resistance between each group of vehicle body fasteners and the battery is acquired by the detection circuit, wherein the detected value of the contact resistance between each group of vehicle body fasteners and the battery is the sum of the detected values of the contact resistances between the respective vehicle body fasteners in this group and the battery.

It should be noted that wires may be arranged between the vehicle body detection points and between the battery detection points to implement the series connection between the multiple vehicle body detection points and between the multiple battery detection points.

Step S14: comparing the detected value of the contact resistance between each group of vehicle body fasteners and the battery with a contact resistance threshold between each group of corresponding vehicle body fasteners and the battery; wherein the contact resistance threshold between each group of vehicle body fasteners and the battery is the sum of contact resistance thresholds between the respective vehicle body fasteners in this group and the battery; and determining that the battery is firmly connected to the vehicle body if the detected value of the contact resistance between each group of vehicle body fasteners and the battery is less than the contact resistance threshold between each group of corresponding vehicle body fasteners and the battery, otherwise determining that the battery is loosely connected to the vehicle body.

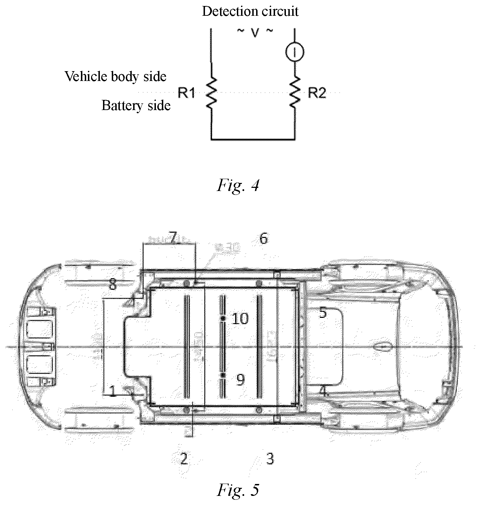

It should be noted that the detection circuit is a circuit for detecting the resistance between two points, and any detection circuit that can detect the resistance between two points is suitable for this. For example, the detection circuit may comprise a voltmeter and an ammeter, and the resistance value between two points can be obtained by detecting the voltage and current, as shown in Fig. 4. In addition, the contact resistance threshold between each of the vehicle body fasteners and the battery is set according to material parameters corresponding to the positions where each of the vehicle body fasteners and the battery are located, and the material parameters comprise one or more of the following: thickness, density, electrical conductivity, and a resistance value measured when the vehicle body fastener is connected and fastened to the battery.

Since the loose connection of fasteners within a certain range is within the safe range, in order to prevent an alarm from being given when within the safe range, an error range can be set for the threshold to further improve the detection accuracy. For example, assuming that the threshold is Q, the error range is set to ± 5% Q, that is, assuming that Q = 10, when the detected value is 10.2, it is not determined as a loose state. It is determined as a loose connection only when the detected value exceeds 10.5. When the detected value is 9.8, it is not determined as a firm connection state. Only when the detected value is less than 9.5, it is determined as the firm connection state. When the detected value is 9.5-10.5, it is also a safety state such that no alarm is given, and the vehicle can continue to drive safely.

In the second embodiment, the method further comprises, if a detected value of the contact resistance between one group of vehicle body fasteners and the battery is greater than or equal to a contact resistance threshold between this group of corresponding vehicle body fasteners and the battery, re-grouping the vehicle body fasteners in this group for contact resistance detection, so as to determine all loose vehicle body fasteners.

The second embodiment is described in detail below through specific examples.

It is assumed that a vehicle chassis and the installation position of a battery on the chassis are shown in Fig. 5, and the battery and the chassis are directly fixed via 10 vehicle body fasteners numbered 1-10 respectively.

If the vehicle body fasteners No. 1 and No. 2 fall into one group for detection, the vehicle body fasteners No. 1 and No. 2 can be short-circuited inside the battery. On the vehicle body side, the detection circuit is connected to detect the contact resistance. Assuming that the resistance value is detected by measuring the voltage value and the current value, it can be V/I = R1 + R2. Assuming that the contact resistance thresholds corresponding to connection points No. 1 and No. 2 are both R', when the detected value is less than 2R', it is determined that connection points No. 1 and No. 2 are firmly connected; otherwise it can be determined that the connection points No. 1 and No. 2 are loose. Which connection point is loose can be further determined for reinforcement, or the two connection points can be directly reinforced.

It can be understood that the series connection of R1 and R2 is only one way of combination. In the detection process, any pair of resistors can be connected in series, and the contact resistance can then be detected at two ends. When the resistance value is found abnormal, which resistor is abnormal can be further determined.

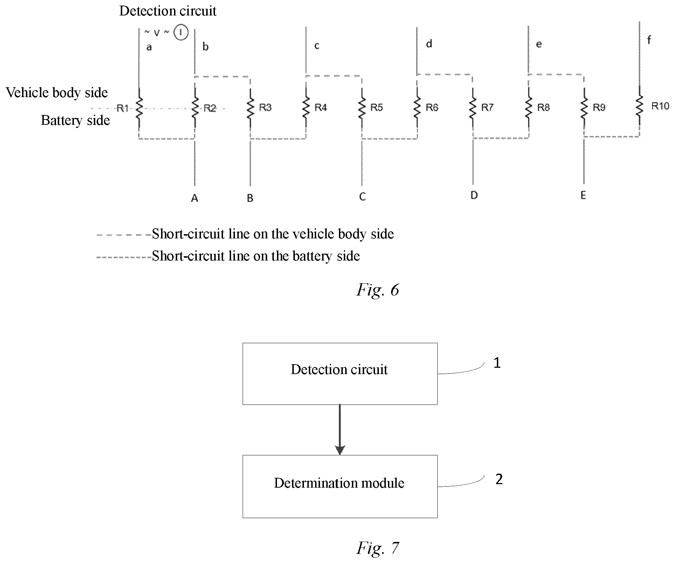

As shown in Fig. 6, it is assumed that there are 10 connections corresponding to R1-R10. Detection points a-f are provided on the vehicle body side and detection points A-E are provided on the battery side.

The resistance value between the detection points a and b is detected and is R1+R2.

The resistance value between the detection points A and B is detected and is R2+R3.

If R1+R2 ≤ 2R' and R2+R3 ≥ 2R', the vehicle body fastener corresponding to R3 can be located as the abnormal connection point.

If R1+R2 ≥ 2R' and R2+R3 ≥ 2R', the vehicle body fastener corresponding to R2 can be located as the abnormal connection.

The integral detection may also be directly performed during the detection process: the resistance value between the detection points a and f is detected first to determine whether the value is less than 10R', and if it is less than 10R', it is determined that the integral connection is normal. Otherwise, the vehicle body fasteners can be re-grouped for detection until the vehicle body fastener with abnormal connection is found. For example, the resistance value between adjacent detection points can be determined in sequence to find the abnormal connection position, and this can prompt which vehicle body fastener is in a loose state.

According to the method of the invention, whether a battery and a vehicle body of a vehicle after battery swapping are firmly connected can be quantitatively detected through a contact resistance. Detection can be performed after the battery swapping is completed to ensure the battery is firmly installed; moreover, real-time detection can also be performed to ensure the battery is firmly connected, and alarm information can be sent when the battery is not firmly connected. In the invention, the detection process is simple, and detection results are reliable, thereby ensuring the reliability and safety of battery swapping and the safe driving of the vehicle after battery swapping, and preventing the battery from falling.

An embodiment of the invention further provides an apparatus for detecting a connection state between a battery of an electric vehicle and a vehicle body. As shown in Fig. 7, the battery of the electric vehicle is connected to the vehicle body via vehicle body fasteners. The apparatus comprises a detection circuit 1 and a determination module 2, wherein the detection circuit 1 is connected to the determination module 2. The detection circuit 1 connects vehicle body detection points or battery detection points and is configured for detecting a contact resistance between one or more vehicle body fasteners and the battery to obtain a detected value of the contact resistance. The determination module 2 is configured for determining the connection state between the battery and the vehicle body according to the detected value of the contact resistance and a preset contact resistance threshold. The apparatus further comprises an alarm module connected to the determination module and configured for giving an alarm when it is determined that the battery is in loose connection with the vehicle body, so as to remind a vehicle owner that the battery is loose and to prevent dangerous driving.

Two embodiments are given below for detailed description.

### Third Embodiment

The detection circuit 1 is further configured for connecting each vehicle body detection point to a corresponding battery detection point, and detecting a contact resistance between each of the vehicle body fasteners and the battery one by one to obtain a detected value of the contact resistance between each of the vehicle body fasteners and the battery.

The vehicle body detection points are located on vehicle body fasteners on the vehicle body side, the battery detection points are located on the battery side, and each of the vehicle body detection points corresponds to one battery detection point. As shown in Fig. 3, a firm connection state and a loose connection state, as well as positions of detection points on the vehicle body side and on the battery side are shown respectively.

The determination module 2 is configured for:
comparing the detected value of the contact resistance between each of the vehicle body fasteners and the battery with a contact resistance threshold between the corresponding vehicle body fastener and the battery; and
determining that the battery is firmly connected to the vehicle body if the detected value of the contact resistance between each of the vehicle body fasteners and the battery is less than the contact resistance threshold between the corresponding vehicle body fastener and the battery, otherwise determining that the battery is loosely connected to the vehicle body.

The determination module 2 can also compare the sum of the detected values of the contact resistances between all the vehicle body fasteners and the battery with the sum of contact resistance thresholds between all the corresponding vehicle body fasteners and the battery; if the sum of the detected values of the contact resistances between all the vehicle body fasteners and the battery is less than the sum of the contact resistance thresholds between all the corresponding vehicle body fasteners and the battery, it is determined that the battery is firmly connected to the vehicle body, otherwise it is determined that the battery is loosely connected to the vehicle body.

### Fourth Embodiment

In the actual detection process, since the way to detect a single contact resistance described in the third embodiment is directly used, a detection loop needs to be established between the vehicle body and the battery, and the detection process is relatively difficult. Therefore, the following apparatus can be used for detection:
the apparatus further comprises a grouping module:
assuming that there are **M** vehicle body fasteners on an electric vehicle, where **M** is an integer greater than or equal to 2,
the grouping module is configured for dividing the **M** vehicle body fasteners into **N** groups, where **N** is an integer greater than or equal to 1, each group comprising **P** vehicle body fasteners, where **2** ≤ **P** ≤ **M,** and the **N** groups of fasteners comprising every vehicle body fastener on the vehicle, wherein each of the vehicle body fasteners is provided with one of the vehicle body detection points, the battery detection points are all located on the battery side, and each of the vehicle body detection points corresponds to one battery detection point.

It should be noted that the grouping module has multiple grouping methods, which can be set according to specific detection requirements. For example, they can be detected in pairs, that is, two-by-two detection, or three, four, etc. fasteners per group may be detected. The number of vehicle body fasteners contained in each group may be the same or different, and the same vehicle body fastener may be assigned to multiple groups, as long as all the vehicle body fasteners are grouped.

The apparatus further comprises a series connection unit configured for connecting in series vehicle body detection points on the vehicle body side that correspond to all the vehicle body fasteners in each group, and reserving the vehicle body detection points at two ends; or
for connecting in series battery detection points on the battery side that correspond to all the vehicle body fasteners in each group, and reserving the battery detection points at two ends.

The detection circuit 1 is configured for: connecting the reserved vehicle body detection points at the two ends on the vehicle body side, or connecting the reserved battery detection points at the two ends on the battery side, and detecting a contact resistance between each group of vehicle body fasteners and the battery to obtain a detected value of the contact resistance between each group of vehicle body fasteners and the battery, wherein the detected value of the contact resistance between each group of vehicle body fasteners and the battery is the sum of the detected values of the contact resistances between the respective vehicle body fasteners in this group and the battery.

The determination module 2 is configured for: comparing the detected value of the contact resistance between each group of vehicle body fasteners and the battery with a contact resistance threshold between each group of corresponding vehicle body fasteners and the battery;
wherein the contact resistance threshold between each group of vehicle body fasteners and the battery is the sum of contact resistance thresholds between the respective vehicle body fasteners in this group and the battery; and
determining that the battery is firmly connected to the vehicle body if the detected value of the contact resistance between each group of vehicle body fasteners and the battery is less than the contact resistance threshold between each group of corresponding vehicle body fasteners and the battery, otherwise determining that the battery is loosely connected to the vehicle body.

It should be noted that any detection circuit that can detect the resistance between two points is suitable for this. For example, the detection circuit may comprise a voltmeter and an ammeter, and the resistance value between two points can be obtained by detecting the voltage and current, as shown in Fig. 4. In addition, the contact resistance threshold between each of the vehicle body fasteners and the battery is set according to material parameters corresponding to the positions where each of the vehicle body fasteners and the battery are located, and the material parameters comprise one or more of the following: thickness, density, electrical conductivity, etc.

Since the loose connection of fasteners within a certain range is within the safe range, in order to prevent an alarm from being given when within the safe range, an error range can be set for the threshold to further improve the detection accuracy. For example, assuming that the threshold is Q, the error range is set to ± 5% Q, that is, assuming that Q = 10, when the detected value is 10.2, it is not determined as a loose state. It is determined as a loose connection only when the detected value exceeds 10.5. When the detected value is 9.8, it is not determined as a firm connection state. Only when the detected value is less than 9.5, it is determined as the firm connection state. When the detected value is 9.5-10.5, it is also a safety state such that no alarm is given, and the vehicle can continue to drive safely.

In the fourth embodiment, the determination module 2 determines that a detected value of the contact resistance between a group of vehicle body fasteners and the battery is greater than or equal to a contact resistance threshold between this group of corresponding vehicle body fasteners and the battery, the grouping module can re-group the vehicle body fasteners in this group for contact resistance detection, and the determination module 2 then determines all the loose vehicle body fasteners.

According to the apparatus of the invention, whether a battery and a vehicle body of a vehicle after battery swapping are firmly connected can be quantitatively detected through a contact resistance. Detection can be performed after the battery swapping is completed to ensure the battery is firmly installed; moreover, real-time detection can also be performed to ensure the battery is firmly connected, and alarm information can be sent when the battery is not firmly connected. In the invention, the detection process is simple, and detection results are reliable, thereby ensuring the reliability and safety of battery swapping and the safe driving of the vehicle after battery swapping, and preventing the battery from falling.

An embodiment further provides a controller, which comprises a memory and a processor, wherein the memory stores a computer program which, when executed by the processor, is capable of implementing the steps of the method.

An embodiment further provides a computer readable storage medium for storing a computer program, wherein the program, when executed by a computer or a processor, implements the steps of the method.

The foregoing descriptions are merely preferred embodiments of the invention, and are not intended to limit the invention in any form. Although the invention has been disclosed as above by means of the preferred embodiments, these embodiments are not for the purpose of limiting the invention. Those skilled in the art can make alterations or modifications to the technical contents disclosed above without departing from the technical solutions of the invention so as to arrive at equivalent embodiments with equivalent changes. However, any simple amendments, equivalent changes and modifications made to the above embodiments according to the technical essence of the invention without departing from the technical solutions of the invention are still within the scope of the technical solutions of the invention.

## Claims

1. A method for detecting a connection state between a battery and a vehicle body, **characterized by** comprising:
detecting a contact resistance between one or more vehicle body fasteners and the battery to obtain a detected value of the contact resistance; and
determining the connection state between the battery and the vehicle body according to the detected value of the contact resistance and a preset contact resistance threshold.

2. The method for detecting a connection state between a battery and a vehicle body according to claim 1, **characterized in that**
the step of detecting a contact resistance between one or more vehicle body fasteners and the battery to obtain a detected value of the contact resistance comprises:
detecting a contact resistance between each of the vehicle body fasteners and the battery one by one to obtain a detected value of the contact resistance between each of the vehicle body fasteners and the battery.

3. The method for detecting a connection state between a battery and a vehicle body according to claim 2, **characterized in that**
the step of detecting a contact resistance between each of the vehicle body fasteners and the battery one by one to obtain a detected value of the contact resistance between each of the vehicle body fasteners and the battery comprises:
connecting a detection circuit between each of vehicle body detection points and a corresponding battery detection point; and
acquiring a contact resistance value between each of the vehicle body detection points and the corresponding battery detection point by the detection circuit,
wherein each of the vehicle body fasteners is provided with one of the vehicle body detection points, the battery detection points are all located on the battery side, and each of the vehicle body detection points corresponds to one battery detection point.

4. The method for detecting a connection state between a battery and a vehicle body according to claim 2, **characterized in that**
the step of determining the connection state between the battery and the vehicle body according to the detected value of the contact resistance and a preset contact resistance threshold comprises the following steps of:
comparing the detected value of the contact resistance between each of the vehicle body fasteners and the battery with a contact resistance threshold between the corresponding vehicle body fastener and the battery; and
determining that the battery is firmly connected to the vehicle body if the detected value of the contact resistance between each of the vehicle body fasteners and the battery is less than the contact resistance threshold between the corresponding vehicle body fastener and the battery, otherwise determining that the battery is loosely connected to the vehicle body.

5. The method for detecting a connection state between a battery and a vehicle body according to claim 1, **characterized in that**
the step of detecting a contact resistance between one or more vehicle body fasteners and the battery to obtain a detected value of the contact resistance comprises:
assuming that there are **M** vehicle body fasteners on an electric vehicle, where **M** is an integer greater than or equal to 2,
dividing the **M** vehicle body fasteners into **N** groups, where **N** is an integer greater than or equal to 1, each group comprising **P** vehicle body fasteners, where **2** ≤ **P** ≤ **M,** and the **N** groups of fasteners comprising every vehicle body fastener on the vehicle; and
detecting a contact resistance between each group of vehicle body fasteners and the battery to obtain a detected value of the contact resistance between each group of vehicle body fasteners and the battery,
wherein each of the vehicle body fasteners is provided with one vehicle body detection point, the battery detection points are all located on the battery side, and each of the vehicle body detection points corresponds to one battery detection point.

6. The method for detecting a connection state between a battery and a vehicle body according to claim 5, **characterized in that**
the step of detecting a contact resistance between each group of vehicle body fasteners and the battery to obtain a detected value of the contact resistance between each group of vehicle body fasteners and the battery comprises:
on the vehicle body side, connecting in series vehicle body detection points corresponding to all the vehicle body fasteners in each group, and reserving the vehicle body detection points at two ends;
on the battery side, connecting a detection circuit between battery detection points corresponding to the vehicle body detection points at the two ends; and
acquiring a detected value of the contact resistance between each group of vehicle body fasteners and the battery by the detection circuit, wherein the detected value of the contact resistance between each group of vehicle body fasteners and the battery is the sum of the detected values of the contact resistances between the respective vehicle body fasteners in this group and the battery.

7. The method for detecting a connection state between a battery and a vehicle body according to claim 5, **characterized in that**
the step of detecting a contact resistance between each group of vehicle body fasteners and the battery to obtain a detected value of the contact resistance between each group of vehicle body fasteners and the battery comprises:
on the battery side, connecting in series battery detection points corresponding to all the vehicle body fasteners in each group, and reserving the battery detection points at two ends;
on the vehicle body side, connecting a detection circuit between battery detection points corresponding to the battery detection points at the two ends; and
acquiring a detected value of the contact resistance between each group of vehicle body fasteners and the battery by the detection circuit, wherein the detected value of the contact resistance between each group of vehicle body fasteners and the battery is the sum of the detected values of the contact resistances between the respective vehicle body fasteners in this group and the battery.

8. The method for detecting a connection state between a battery and a vehicle body according to any one of claims 5 to 7, **characterized in that**
the step of determining the connection state between the battery and the vehicle body according to the detected value of the contact resistance and a preset contact resistance threshold comprises:
comparing the detected value of the contact resistance between each group of vehicle body fasteners and the battery with a contact resistance threshold between each group of corresponding vehicle body fasteners and the battery;
wherein the contact resistance threshold between each group of vehicle body fasteners and the battery is the sum of contact resistance thresholds between the respective vehicle body fasteners in this group and the battery; and
determining that the battery is firmly connected to the vehicle body if the detected value of the contact resistance between each group of vehicle body fasteners and the battery is less than the contact resistance threshold between each group of corresponding vehicle body fasteners and the battery, otherwise determining that the battery is loosely connected to the vehicle body.

9. The method for detecting a connection state between a battery and a vehicle body according to claim 4 or 8, **characterized in that**
the contact resistance threshold between each of the vehicle body fasteners and the battery is set according to material parameters corresponding to the positions where each of the vehicle body fasteners and the battery are located, and the material parameters comprise one or more of the following: thickness, density, electrical conductivity, and a resistance value measured when the vehicle body fastener is connected and fastened to the battery.

10. The method for detecting a connection state between a battery and a vehicle body according to claim 8, **characterized in that**
if a detected value of the contact resistance between one group of vehicle body fasteners and the battery is greater than or equal to a contact resistance threshold between this group of corresponding vehicle body fasteners and the battery, the vehicle body fasteners in this group are re-grouped for contact resistance detection, so as to determine all loose vehicle body fasteners.

11. The method for detecting a connection state between a battery and a vehicle body according to any one of claims 1 to 7, **characterized in that**
the method further comprises giving an alarm if it is determined that the battery is in loose connection with the vehicle body.

12. An apparatus for detecting a connection state between a battery and a vehicle body, the battery being connected to the vehicle body via a vehicle body fastener, **characterized in that** the apparatus comprises a detection circuit and a determination module, and the detection circuit is connected to the determination module;
the detection circuit connects vehicle body detection points or battery detection points and is configured for detecting a contact resistance between one or more vehicle body fasteners and the battery to obtain a detected value of the contact resistance; and
the determination module is configured for determining the connection state between the battery and the vehicle body according to the detected value of the contact resistance and a preset contact resistance threshold.

13. The apparatus for detecting a connection state between a battery and a vehicle body according to claim 12, **characterized in that**
the detection circuit is further configured for connecting each vehicle body detection point to a corresponding battery detection point, and detecting a contact resistance between each of the vehicle body fasteners and the battery one by one to obtain a detected value of the contact resistance between each of the vehicle body fasteners and the battery,
wherein each of the vehicle body fasteners is provided with one of the vehicle body detection points, the battery detection points are all located on the battery side, and each of the vehicle body detection points corresponds to one battery detection point.

14. The apparatus for detecting a connection state between a battery and a vehicle body according to claim 13, **characterized in that**
the determination module is further configured for:
comparing the detected value of the contact resistance between each of the vehicle body fasteners and the battery with a contact resistance threshold between the corresponding vehicle body fastener and the battery; and
determining that the battery is firmly connected to the vehicle body if the detected value of the contact resistance between each of the vehicle body fasteners and the battery is less than the contact resistance threshold between the corresponding vehicle body fastener and the battery, otherwise determining that the battery is loosely connected to the vehicle body.

15. The apparatus for detecting a connection state between a battery and a vehicle body according to claim 12, **characterized in that**
the apparatus further comprises a grouping module:
assuming that there are **M** vehicle body fasteners on an electric vehicle, where **M** is an integer greater than or equal to 2,
the grouping module is configured for dividing the **M** vehicle body fasteners into **N** groups, where **N** is an integer greater than or equal to 1, each group comprising **P** vehicle body fasteners, where **2** ≤ **P** ≤ **M,** and the **N** groups of fasteners comprising every vehicle body fastener on the vehicle,
wherein each of the vehicle body fasteners is provided with one of the vehicle body detection points, the battery detection points are all located on the battery side, and each of the vehicle body detection points corresponds to one battery detection point.

16. The apparatus for detecting a connection state between a battery and a vehicle body according to claim 15, **characterized in that**
the apparatus further comprises a series connection unit configured for connecting in series vehicle body detection points on the vehicle body side that correspond to all the vehicle body fasteners in each group, and reserving the vehicle body detection points at two ends; or
for connecting in series battery detection points on the battery side that correspond to all the vehicle body fasteners in each group, and reserving the battery detection points at two ends.

17. The apparatus for detecting a connection state between a battery and a vehicle body according to claim 16, **characterized in that**
the detection circuit is further configured for: connecting the reserved vehicle body detection points at the two ends on the vehicle body side, or connecting the reserved battery detection points at the two ends on the battery side, and detecting a contact resistance between each group of vehicle body fasteners and the battery to obtain a detected value of the contact resistance between each group of vehicle body fasteners and the battery, wherein the detected value of the contact resistance between each group of vehicle body fasteners and the battery is the sum of the detected values of the contact resistances between the respective vehicle body fasteners in this group and the battery.

18. The apparatus for detecting a connection state between a battery and a vehicle body according to claim 15, **characterized in that**
the determination module is further configured for: comparing the detected value of the contact resistance between each group of vehicle body fasteners and the battery with a contact resistance threshold between each group of corresponding vehicle body fasteners and the battery;
wherein the contact resistance threshold between each group of vehicle body fasteners and the battery is the sum of contact resistance thresholds between the respective vehicle body fasteners in this group and the battery; and
determining that the battery is firmly connected to the vehicle body if the detected value of the contact resistance between each group of vehicle body fasteners and the battery is less than the contact resistance threshold between each group of corresponding vehicle body fasteners and the battery, otherwise determining that the battery is loosely connected to the vehicle body.

19. The apparatus for detecting a connection state between a battery and a vehicle body according to claim 14 or 18, **characterized in that**
the contact resistance threshold between each of the vehicle body fasteners and the battery is set according to material parameters corresponding to the positions where each of the vehicle body fasteners and the battery are located, and the material parameters comprise one or more of the following: thickness, density and electrical conductivity.

20. The apparatus for detecting a connection state between a battery and a vehicle body according to claim 12, **characterized in that**
the apparatus further comprises an alarm module connected to the determination module and configured for giving an alarm when it is determined that the battery is in loose connection with the vehicle body.

21. A controller, comprising a memory and a processor, wherein the memory stores a computer program which, when executed by the processor, is capable of implementing the steps of the method according to any one of claims 1 to 11.

22. A computer readable storage medium for storing a computer program, wherein the program, when executed by a computer or a processor, implements the steps of the method according to any one of claims 1 to 11.
